# EUROPÄISCHE PATENTSCHRIFT

(11) **EP 1 661 215 B1**
(45) Veröffentlichungstag und Bekanntmachung des Hinweises auf die Patenterteilung: **23.04.2014**
(21) Anmeldenummer: 04764705.2
(22) Anmeldetag: 01.09.2004
(51) Int. Cl.: G01D 11/00, H05K 7/14, H01R 24/28, H01R 4/56, G01F 23/26, G01N 11/16, H01R 31/06, H01R 101/00

(54) **FELDGERÄT ZUR BESTIMMUNG UND/ODER ÜBERWACHUNG EINER PROZESSGRÖSSE**
FIELD DEVICE FOR DETERMINING AND/OR MONITORING A PROCESS VARIABLE
DISPOSITIF A EFFET DE CHAMP POUR DETERMINER ET/OU SURVEILLER UNE GRANDEUR DE PROCESSUS

(30) Priorität: 01.09.2003 DE 20313695 U
(43) Veröffentlichungstag der Anmeldung: 31.05.2006
(73) Patentinhaber: Endress + Hauser GmbH + Co. KG, 79689 Maulburg (DE)
(72) Erfinder: SCHMIDT, Robert, 79650 Schopfheim (DE); RUPP, Armin, 79576 Weil am Rhein (DE); HENKEL, Ira, 79650 Schopfheim (DE)
(74) Vertreter: Andres, Angelika Maria
(86) Internationale Anmeldenummer: PCT/EP2004/009744
(87) Internationale Veröffentlichungsnummer: WO 2005/025015

(56) Entgegenhaltungen:
- EP-A- 0 984 248
- EP-A- 1 301 061
- DE-A1- 2 721 802
- DE-A1- 3 115 864
- US-A- 4 867 709
- US-A- 4 943 245

## Beschreibung

Die Erfindung bezieht sich auf ein Feldgerät zur Bestimmung und/oder Überwachung mindestens einer physikalischen oder chemischen Prozessgröße eines Mediums, mit mindestens einem Sensor, mit mindestens einer Elektronikeinheit, und mit mindestens einer Adaptereinheit zwischen Sensor und Elektronikeinheit, die mindestens ein elektrisches Signal vom Sensor zur Elektronikeinheit überträgt. Bei der Prozessgröße kann es sich beispielsweise um den Füllstand, die Viskosität, die Dichte oder den pH-Wert des Mediums in einem Behälter handeln. Die Messmethode kann dabei beispielsweise kapazitiv oder konduktiv sein, auf der Vibronik oder auf einem Laufzeitverfahren beruhen.

Von der Anmelderin werden kapazitive Feldgeräte zur Bestimmung und/oder Überwachung des Füllstandes eines Mediums in einem Behälter erzeugt und vertrieben. Bei diesen kapazitiven Feldgeräten bilden ein Sensor - meist eine Messsonde - und die Behälterwand oder eine zweite Sonde die Elektroden eines Kondensators. Die Kapazität dieses Kondensators hängt von der Füllhöhe des Mediums ab. Bei der Vibronik ist der Sensor beispielsweise eine Schwinggabel, deren Schwingfrequenz und -amplitude von der Bedeckung der Gabel durch das Medium abhängt. Diese Feldgeräte bestehen zumeist aus dem angesprochenen Sensor und einer Elektronikeinheit mit zumindest einer Regel/Steuereinheit, einer Auswerte- und einer Anzeigeinheit in einem entsprechenden Gehäuse. Eine solche Ausgestaltung lässt sich beispielsweise der EP 0 984 248 der Anmelderin entnehmen. Da diese Elektronikeinheit meist sehr kompakt ausgeführt ist und da sie als eine meist in sich abgeschlossene Einheit in das Gehäuse eingesetzt wird, besteht auch die Bezeichnung Elektronikeinsatz. Zwischen dem Sensor und dem Elektronikabschnitt befindet sich üblicherweise eine Adaptereinheit, die mindestens ein Signal - das eigentliche Messsignal sollte mindestens übertragen werden - vom Sensor abgreift und es zur Elektronikeinheit weiterleitet. Unter Adaptereinheit sei im folgenden eine Einheit verstanden, die derartig ausgestaltet wird, dass mindestens ein Sensorsignal abgegriffen und an die Elektronikeinheit im entsprechenden Format übermittelt wird. Ein solcher Adapter ist auch deshalb erforderlich, weil es aus Gründen der Kostenersparnis sinnvoll ist, eine Elektronikeinheit für unterschiedliche Sensoren mit unterschiedlichen Messmethoden zu benutzen. Da je nach Messverfahren unterschiedliche Signale abgegriffen und bereitgestellt werden, da jedoch die Elektronikeinheit im Sinne der Kostenreduktion nur mit einer Art von Signaleingang ausgerüstet ist, müssen die Sensorsignal jeweils passend an diesen Eingang adaptiert werden. Im einfachsten Fall wäre diese Adaptereinheit ein Kabel. Meist werden jedoch das eigentliche Sensorsignal - das Messsignal - und Masse vom Sensor abgegriffen. Das Sensorsignal wird meist über einen Stift und die Masse über eine Litze abgegriffen. Eine solche Litze erlaubt es nur bedingt, dass der Sensor und das Gehäuse, welches die Elektronikeinheit aufnimmt, gegeneinander verdreht werden können, um z.B. die Anzeigeeinheit optimal auszurichten. Daher ist üblicherweise ein Metallstift vorgesehen, der ein Überdrehen verhindert. Dieser Stift bereitet jedoch bei der Fertigung Schwierigkeiten, weil sich z.B. der Aufwand erhöht, und er schränkt auch das Ausrichten ein, da bei einer unglücklichen Situation eine optimale Ausrichtung nicht möglich sein kann.

Somit ist die Aufgabe der Erfindung, ein Feldgerät vorzustellen, bei dem der Sensor und die Elektronikeinheit beliebig, d.h. ohne Begrenzung gegeneinander verdrehbar sind.

Die Angabe wird gelöst durch ein Feldgerät nach Anspruch 1. Dazu wird in der Adaptereinheit mindestens eine um mindestens eine Achse des Feldgerätes beliebig drehbare Kontaktverbindung zum Abgriff des mindestens einen Signals des Sensors vorgesehen ist. In dieser Variante ist die Adaptereinheit so ausgestaltet, dass der Abschnitt für den Signalabgriff selbst über eine Kontakteinheit drehbar ist. Ein weiterer Vorteil neben der beliebigen Verdrehbarkeit besteht darin, dass ebenfalls eine steckbare Verbindung realisiert werden kann. Dies wird in der folgenden Ausgestaltung deutlich werden. Ein großer Vorteil ist, dass so die Fertigung einfacher wird, da die speziellen Arbeitsschritte, um z.B. manuell und in Einzelarbeit die Litze anzubringen, entfallen. Weiterhin werden Fehlerquellen des Standes der Technik eingeschränkt: Der Metallstift zur Beschränkung des Drehens kann nicht abbrechen. Die Litze kann nicht abreißen und auch nicht gequetscht werden. Letzteres führt im Stand der Technik vor allem dazu, dass die Messergebnisse verfälscht werden. Die Adaptereinheit ist entsprechend den Anforderungen der Elektronikeinheit ausgestaltet, bzw. sie weist einen entsprechenden Signalausgang auf. Üblich sind beispielsweise 4-polige Steckerausgänge, wie sie beispielsweise im Liquiphant verwendet werden. Beim Liquiphanten handelt es sich um ein Füllstandsensor, der im Bereich der Vibronik angesiedelt ist, indem die Schwingungen einer Schwinggabel ausgewertet werden. Der Liquiphant wird von der Anmelderin produziert und vertrieben. Die Adaptereinheit selbst ist üblicherweise ebenfalls mit elektronischen Bauteilen bestückt, die z.B. der Signalumwandlung dienen. Das Messprinzip selbst ist beliebig.

Die Erfindung sieht vor, dass es sich bei der Kontaktverbindung um einen Schleifkontakt handelt. Diese Ausgestaltung realisiert sehr einfach die beliebige Verdrehbarkeit, bei der das Sensorsignal stets gut abgegriffen wird.

Besondere Vorteile für die Fertigung, aber auch für den Austausch vor Ort ergeben sich, wenn der Sensor und die Elektronikeinheit steckbar miteinander zu verbinden sind. Dies ergibt sich durch folgende Ausgestaltung der ersten Lösungsvariante.

Die Erfindung beinhaltet, dass in der Adaptereinheit mindestens eine innere und mindestens eine äußere Kontaktverbindung vorgesehen sind, welche konzentrisch um die Achse des Feldgerätes angeordnet sind. Eine Kontaktverbindung ist beispielsweise für den Abgriff des eigentlichen Sensorsignals, also des Messsignals, und die zweite Kontaktverbindung für den Abgriff eines Masse- oder Guardsignals vorgesehen. Angeordnet sind beide Kontaktverbindungen konzentrisch oder auch koaxial, wobei sie sich jedoch nicht vollständig umgeben müssen. Wichtig bei dieser Ausgestaltung ist, dass zumindest eine Kontaktverbindung so um die andere angeordnet ist, dass dadurch die Adaptereinheit immer noch um eine Achse drehbar ist. Daher die konzentrische oder koaxiale Anordnung mit Positionierungen der Verbindungen auf unterschiedlichen Radien zur Achse, um die die Drehbarkeit erwünscht ist. Diese konzentrische oder koaxiale Anordnung erlaubt also über die Ausnutzung unterschiedlicher Höhen - d.h. relative Abstände zum Sensor entlang einer gleiche Achse - und unterschiedliche Radien den Abgriff mehrerer Signale. Die Adaptereinheit muss nur entsprechend ausgestaltet werden, d.h. beispielsweise länger sein. Eine Möglichkeit ist auch, dass es sich bei der inneren Kontaktverbindung um einen üblichen Stecker handelt, und dass die äußere Kontaktverbindung ebenfalls ein Stecker ist, der in einer kreisförmigen Nut im Sensor um die Position des inneren Steckers umläuft, ähnlich dem Tonarm bei einer Schallplatte. Diese Ausgestaltung hat ebenfalls den Vorteil, steckbar zu sein. Diese konzentrische oder koaxiale Ausgestaltung erlaubt es, dass alle Kontakte für den Abgriff der jeweiligen Signale - beispielsweise das eigentliche Sensor-Signal, Masse, Guard - gleichzeitig hergestellt werden. Dies vereinfacht die Montage. Dadurch lassen sich beispielsweise auch Dichtfunktionen einfacher gestalten. Weiterhin besteht ein Vorteil darin, dass der Abgriff der Signale und der Bereich der Elektronik besser und mehr voneinander getrennt sind.

Die Erfindung sieht vor, dass es sich bei der inneren Kontaktverbindung um einen Schleifkontakt in Form eines Lamellensteckers handelt, und dass die äußere Kontaktverbindung mindestens eine als Schleifkontakt wirkende Lamelle aufweist. Dies ermöglicht sehr einfach die koaxiale, drehbare und steckbare Ausgestaltung. Die Lamelle sei dabei so verstanden, dass es sich um eine Einheit handelt, die federnd ist, so dass sich stets eine schleifende Verbindung herstellen lässt. Es kann sich also um einen Blechstreifen, aber auch um einen entsprechend ausgestalteten Draht oder um eine Drahtfeder handelt. Es kann auch ein starres Metallstück sein, dass entsprechend federnd gelagert ist, so dass über den Andruck der Feder die Schleikontakt-Funktion erfüllt wird. Durch diese Ausgestaltungen ist auch nach mehrmaligem Drehen der Abgriff durch den Schleifkontakt immer noch gewährleistet. Weiterhin ist die Ausgestaltung der Lamelle auch dadurch bestimmt, dass sie eine seitliche Stabilität aufweist, was für die Drehbarkeit und die stets möglichst optimale Schleifkontaktfunktion wichtig ist. Der Schleifkontakt besteht in einer Ausgestaltung aus einzelnen federnden Lamellen, die so in der Adaptereinheit befestigt sind, dass die Anordnung dabei steckbar bleibt. Die Lamellen reichen dafür beispielsweise nur in einem mittleren Bereich aus der Adaptereinheit heraus und auch nur so weit, dass der elektrische Kontakt mit dem Sensor optimal hergestellt wird, dass es jedoch beim Stecken der Adaptereinheit in das Feldgerät nicht zu einem Verhaken der Lamellen kommt. Je nach Ausgestaltung kann so auch die federnde Eigenschaft des Schleifkontaktes realisiert werden. Der Vorteil einer federnden Lagerung ist, dass die mechanische Belastung z.B. durch Vibrationen und auch durch Fertigungs-Toleranzen vermindert werden kann. Bei weiteren Ausgestaltungen können zusätzliche Kontaktverbindungen dadurch realisiert werden, dass die entsprechenden Lamellen zueinander versetzt sind, z.B. im Winkel von 90° zueinander stehen. Dies und auch die anderen Ausgestaltungen erfordern natürlich, dass auch die Sensoreinheit so ausgestaltet ist, dass die Signale entsprechend der Adaptereinheit abgegriffen werden können.

Eine vorteilhafte Ausgestaltung sieht vor, dass der Bereich der Lamellen des Lamellensteckers derartig relativ zum Anschlag des Lamellensteckers angeordnet ist, dass möglichst optimal große Abstandsschwankungen zwischen Sensor und Adaptereinheit ausgleichbar sind. Diese Ausgestaltung ist entsprechend mit der Ausgestaltung der Sensoreinheit verbunden, dass also diese Art des Abstands- oder Höhenausgleichs auch zum Tragen kommen kann. Die Idee besteht darin, dass die Lamellen möglichst weit vorne sitzen, also schon sehr früh Kontakt mit dem Sensor haben. Der Bereich bis zum Anschlag kann dann zum Ausgleich der Höhe dienen. Ist somit der Abstand zwischen den Lamellen und dem Anschlag des Sensors möglichst groß, so können auch größere Höhenunterschiede ausgeglichen werden. Solche Höhenunterschiede können durch Fertigungstoleranzen auftreten, es kann jedoch auch sein, dass sich der Sensor durch Temperatureinflüsse über längere Zeiträume verändert.

Die Erfindung sieht vor, dass mindestens die innere Kontaktverbindung federnd gelagert ist. Eine solche federnde Lagerung oder Befestigung führt dazu, dass der auf die Adaptereinheit wirkende Druck nicht zu groß werden kann und dass auch Winkel- oder Achsversatz des Sensors beim Einbau oder bei der zeitlichen Veränderung ausgeglichen werden kann. Es handelt sich dabei beispielsweise um Blatt- oder Zugfedern oder um ein Blech, welches so ausgestaltet und mit der inneren Kontaktverbindung - dem Lamellenstecker - verbunden ist, dass es nicht vollkommen starr ist. Eine solche federnde Befestigung/Lagerung bedeutet ebenfalls, dass es sich um eine plastisch verformbare Befestigung handelt, dass sich also die Lagerungseinheit bei der Montage derart verformt, dass Bautoleranzen bei der Montage einmal federnd ausgeglichen werden können.

In der ersten Variante der Adaptereinheit ist es jedoch weiterhin möglich, zusätzliche Signale über Litzen, die mit der Adaptereinheit verbunden sind, abzugreifen. Weiterhin lässt sich die Adaptereinheit bei jeder Art von Sensor unabhängig vom Messprinzip anwenden.

Die Aufgabe wird erfindungsgemäß dadurch gelöst, dass in der Adaptereinheit eine Abgreifeinheit zum Abgriff von mindestens einem Signal des Sensors vorgesehen ist, dass in der Adaptereinheit eine Steckereinheit zur Übertragung des mindestens einen Signals des Sensors zur Elektronikeinheit vorgesehen ist, und dass in der Adaptereinheit eine um mindestens eine Achse des Feldgerätes beliebig drehbare Zwischeneinheit zwischen der Abgreifeinheit und der Steckereinheit vorgesehen ist, über die das mindestens eine Signal von der Abgreifeinheit zur Steckereinheit übertragen wird. Die Grundidee ist also, dass sich die Adaptereinheit aus zwei Einheiten zusammensetzt, zwischen denen sich eine drehbare Zwischeneinheit befindet. Über diese Zwischeneinheit werden die Signale von der einen zur anderen Einheit übertragen. Bei dieser Zwischeneinheit kann es sich beispielsweise um eine entsprechend ausgestaltete und mit elektrischen Verbindungen versehene Hohlschraube handeln. Gegenüber der ersten Variante ist also die Umsetzung der Dreh- und Steckbarkeit ein Zwischenteil des Adapters geworden. Auch in dieser zweiten Variante wird die Fertigung enorm vereinfacht, indem die einzelnen Bauteile nur ineinander gesteckt werden müssen. Vor allem kann auch auf den, auch für die Konstruktion schwierigen Metallstift verzichtet werden. Es kann also auch hier in der Anwendung vor Ort nicht zu den oben bei der ersten Variante geschilderten Schwierigkeiten wie Abreißen, Verdrehen der Litze oder Abreißen des Metallstifts kommen. Eine Besonderheit gegenüber der ersten Variante besteht auch darin, dass die Art des Signalabgriffs beim Sensor und die Anzahl der abgegriffenen Signale - je mehr Signale abgegriffen werden, desto schwieriger gestaltet sich die Umsetzung - keinen Einfluss auf die Verdrehbarkeit hat. Es können also beliebig viele Signale vom Sensor abgegriffen werden und dies kann je nach Ausgestaltung auch beliebig kompliziert erfolgen. Die Drehbarkeit ist davon nicht betroffen, weil der Abgriff eine in sich geschlossene Einheit ist. Es muss einzig ermöglicht werden, dass diese beliebige Anzahl an Signalen auch übertragen wird. Durch diese Entkopplung zwischen Signalabgriff und Signalumsetzung für den Elektronikeinsatz ergibt sich also die Drehbarkeit durch die Zwischeneinheit, die daher unbetroffen ist davon, wie der Signalabgriff und die -umsetzung realisiert werden. Auf ein spezielles Messprinzip wird hierbei nicht Bezug genommen, da gerade ein Vorteil darin besteht, eine solche Adaptereinheit für unterschiedliche Feldgeräte einsetzen zu können. In den folgenden Ausgestaltungen wird auf diese Kontaktverbindung eingegangen. Aus praktischen Erwägungen heraus, um z.B. stets einen guten Kontakt und einen sicheren Abgriff zu gewährleisten, liegt es nahe, eine Schleifverbindung zu realisieren.

Eine Ausgestaltung sieht vor, dass es sich bei der drehbaren Zwischeneinheit um einen Klinkenstecker handelt. Unter Klinkenstecker sei hier ein elektrischer Stecker verstanden, von dem sich von einzelnen Segmenten - Spitze und der ganze Schaft oder einzelne Ringe des Schafts - des Steckers unterschiedliche elektrische Signale abgreifen lassen. In der Technik üblich sind solcher Stecker beispielsweise für Kopfhöher. Ein solcher Klinkenstecker ist drehbar und es lassen sich über ihn vor allem mehrere Signale auf jeweils einzelne Abschnitte übertragen. Ein Vorteil ist, dass es prinzipiell keine Beschränkung der Anzahl der übertragbaren Signale gibt, da einfach der Klinkenstecker länger und somit mit mehr Abschnitten ausgestattet werden muss. In einer anderen Ausgestaltung lassen sich jedoch auch einzelne elektrische Leiter verwenden, die einander konzentrisch umgeben.

Eine Ausgestaltung beinhaltet, dass in der Abgreifeinheit mindestens eine Abgreifstelle zum Abgreifen eines Masse- und/oder eines Guardsignals vorgesehen ist. Somit können auch mehrere Signale abgegriffen und der Elektronikeinheit für die Auswertung oder für weitere Verfahren zugeführt werden. Über den Klinkenstecker ist dann auch die Übertragung der Signale sehr einfach.

Eine Ausgestaltung sieht vor, dass in der Steckereinheit mindestens eine Buchse zur Aufnahme der drehbaren Zwischeneinheit vorgesehen ist. In der Steckereinheit ist also eine entsprechende Aufnahmestelle für die drehbare Zwischeneinheit vorgesehen.

Die Erfindung beinhaltet, dass die drehbare Zwischeneinheit und/oder die Buchse federnd gelagert sind/ist. Eine solche federnde Lagerung stellt sicher, dass drehbare Zwischeneinheit und Buchse immer einen guten und sicheren Kontakt haben. Eine feste Lagerung ist jedoch auch möglich.

Die Idee der erfindungsgemäßen Lösung der Aufgabe besteht also darin, dass die Adaptereinheit mindestens einen Abschnitt aufweist, welcher beliebig drehbar und sogar steckbar ist. In der ersten Ausgestaltung ist der Signalabgriff drehbar, indem mindestens ein Schleifkontakt verwendet wird. In der zweiten Variante ist der Übergang zwischen dem Abgriff und dem Bereich des Übergangs zur Elektronik durch den Klinkenstecker drehbar ausgestaltet. Es ist auch möglich, bei einer passenden Ausgestaltung des Sensors, einen Klinkenstecker für die erste Variante als Schleifkontakt zu verwenden. Dies erfordert jedoch einen erhöhten Aufwand für den Sensor. Da der Elektronikeinsatz einen mehrpoligen Steckereingang aufweist, ist hier eine drehbare Ausgestaltung nicht möglich, d.h. die komplementäre Ausgestaltung zur ersten Variante, dass also das Signal oder die Signale durch eine drehbare Ausgestaltung in die Elektronikeinheit übertragen wird/werden, lässt sich aufgrund der Ausgestaltung der Elektronikeinheit nicht realisieren.

Die Erfindung wird anhand der nachfolgenden Zeichnungen näher erläutert.

Es zeigt:
- Fig. 1:: ein kapazitives Feldgerät mit der erfindungsgemäßen Adaptereinheit der zweiten Variante in Explosionsdarstellung;
- Fig. 2:: eine detaillierte Darstellung der Adaptereinheit der zweiten Variante; und
- Fig. 3:: eine angeschnittene Darstellung der Adaptereinheit der ersten Variante;
- Fig. 4:: eine Darstellung der Adaptereinheit der ersten Variante im eingebauten Zustand.

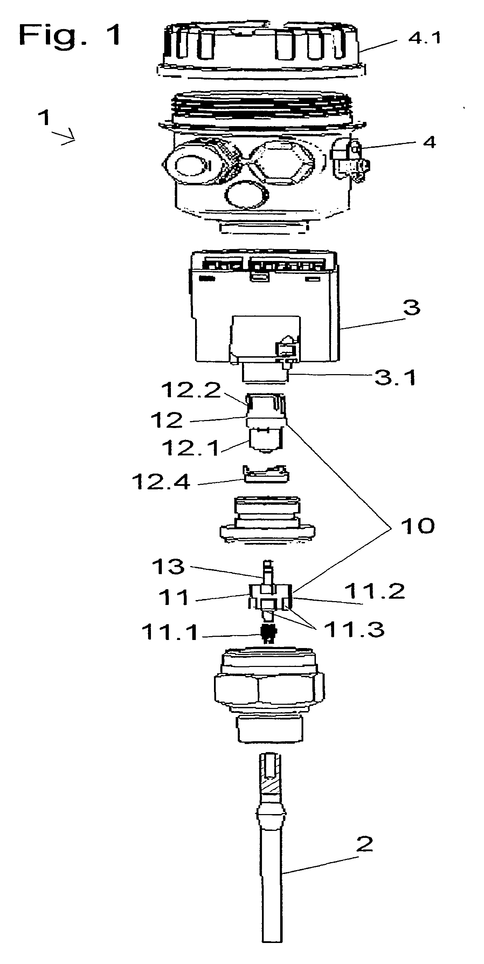

Fig. 1 zeigt ein kapazitives Feldgerät 1. Bei einem solchen Feldgerät 1 bilden ein Sensor 2 - hier ein Sondenstab - und eine Behälterwand oder ein zweiter Sensor (nicht dargestellt) die Elektroden eines Kondensators. Dessen Kapazität ist abhängig vom Füllstand des Mediums zwischen den Elektroden. Somit kann aus der Kapazität auf den Füllstand rückgeschlossen werden. Zu sehen sind weiterhin die erfindungsgemäße Adaptereinheit 10 der zweiten Variante und die Elektronikeinheit 3. Die Elektronikeinheit 3 befindet sich üblicherweise in dem Gehäuse 4, das sich durch einen entsprechenden Deckel 4.1 verschließen lässt (beide befinden sich in der Abbildung oberhalb der Elektronikeinheit 3, umgeben ihn jedoch in der praktischen Ausgestaltung). Die Abgreifeinheit 11 der Adaptereinheit 10 weist einen Lamellenstecker 11.1 auf, über den das Sondensignal abgegriffen wird. Die Abgreifeinheit 11 besteht hier aus dem Lamellenstecker 11.1, einer Platine 11.2 und der drehbaren Zwischeneinheit 13, die hier ein Klinkenstecker ist. Die Platine weist noch zwei weitere Anschlussstellen 11.3 auf, um beispielsweise mit einem Guardsignal oder mit Masse verbunden zu werden. Da diese Signale üblicherweise mit Leitungen oder Litzen abgegriffen werden, ist die Abgreifeinheit 11 vorzugsweise nicht drehbar oder fest mit der Sonde 2 verbunden. Die Platine 11.2 ist dabei so ausgestaltet, dass die entsprechenden Signale vom Lamellenstecker 11.1 oder den Anschlussstellen 11.3 passend auf die einzelnen Einheiten des Klinkensteckers 13 gegeben werden. Je nach der Anzahl der zu übertragenden Signale muss auch der Klinkenstecker 13 ausgestaltet sein. Die Steckereinheit 12 ist so ausgestaltet, dass sie eine Buchse 12.1 für den Klinkenstecker 13 aufweist und dass sie die einzelnen Signale passend abgreifen kann. Der obere Abschnitt der Steckereinheit 12 weist einen entsprechenden Topf 12.2 auf, der in die Elektronikeinheit 3 eingesteckt werden kann. Das Signal oder die Signale werden also vom Sensor 2 über entsprechende Verbindungen mit der Abgreifeinheit 11 abgegriffen. Von dort werden sie über einen Klinkenstecker 13 an die Steckereinheit 12 übertragen und gelangen von dort zur Elektronikeinheit 3. Der Klinkenstecker 13 erlaubt es dabei, den oberen Teil - Elektronik - und den unteren Teil - Sonde/Sensor - des Feldgerätes 1 beliebig gegeneinander zu verdrehen und somit eine optimale Ausrichtung zu erreichen. Die Abgreifeinheit 11 und die Steckereinheit 12 sind vorzugsweise jeweils fest und nicht drehbar fixiert. Die Drehbarkeit ergibt sich dann durch den Klinkenstecker 13. In der hier dargestellten Ausgestaltung ist eine Drehbarkeit um die Längsachse des Feldgerätes 1 gegeben. Wie der Abbildung sehr gut zu entnehmen ist, ist diese erfindungsgemäße Ausgestaltung nicht nur beliebig verdrehbar, sondern lässt sich bei der Montage auch einfach zusammenstecken.

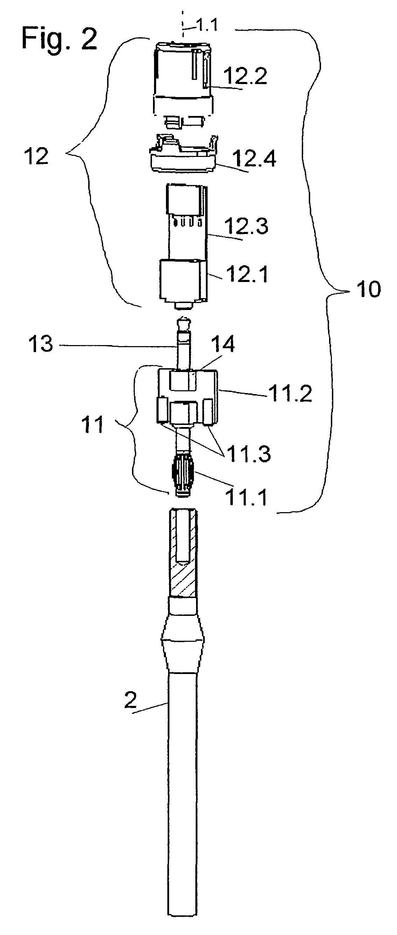

Fig. 2 zeigt detaillierter die Adaptereinheit 10 der zweiten Variante. Der Lamellenstecker 11.1 greift das Signal der Sonde 2 ab. Auf der Platine 11.2 der Abgreifeinheit 11 befinden sich zwei weitere Anschlussstellen 11.3 z.B. für Masse und Guard. Weitere hier nicht dargestellte Komponenten der Abgreifeinheit 11 übertragen die einzelnen Signale auf den Klinkenstecker 13. Die Steckereinheit 12 besteht aus der Buchse 12.1, einer Platine 12.3, einem Haltering 12.4 und einem Topf 12.2. Der Topf 12.2 und die Platine 12.3 sind drehbar im Haltering 12.4 und werden im Hals 3.1 der Elektronikeinheit 3 fixiert. Die Platine 12.3 ist so ausgestaltet, dass die Signale vom Klinkenstecker 13 abgegriffen und entsprechend auf die Elektronikeinheit 3 übertragen werden. Der Klinkenstecker 13 ist über die Feder 14 - es kann sich um eine Spiralfeder, ein entsprechendes Blech oder auch um ein Gummi handeln - an der Platine 11.3 gelagert, so dass auch bei Vibrationen der Kontakt zwischen Klinkenstecker 13 und Buchse 12.1 gegeben ist. Der Klinkenstecker 13 ermöglicht eine Drehbarkeit um die Längsachse 1.1 des Feldgerätes 1, bzw. der Sonde 2.

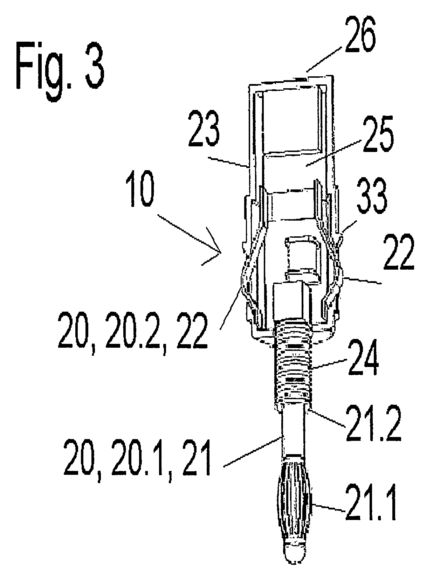

In Fig. 3 ist die erste Variante der Adaptereinheit 10 dargestellt. Die Adaptereinheit 10 ermöglicht über zwei Kontaktverbindungen 20 den Abgriff von zwei Signalen, z.B. das eigentliche Sensorsignal und Masse. Da diese beiden Kontaktverbindungen jeweils Schleifkontakte 21, 22 sind, lässt sich somit die Adaptereinheit 10 beliebig verdrehen. Weiterhin ist über den Aufbau als innere 20.1 und äußere Kontaktverbindung 20.2 auch eine steckbare Verbindung möglich, d.h. die Adaptereinheit 10 wird in den Sensor 2 gesteckt und die Elektronikeinheit 3 wird dann mit der Adaptereinheit 10 verbunden. Das Zusammenstecken ist also sehr einfach. Über die innere Kontaktverbindung 20.1 wird das eigentliche Sensorsignal und über die äußere Kontaktverbindung 20.2 wird beispielsweise die Masse abgegriffen. Die beiden Kontaktverbindungen 20.1 und 20.2 sind konzentrisch oder koaxial angeordnet, wobei sie sich jedoch nicht umgeben, da sie in der Höhe versetzt sind. Durch diese konzentrische oder koaxiale Ausgestaltung können somit auch weitere Abgriffe, z.B. für den Abgriff des Guardsignals realisiert werden. Der Lamellenstecker 21 ist so ausgestaltet, dass eine möglichst große Höhendifferenz ausgeglichen werden kann. Dies ist dadurch realisiert, dass der Bereich des Steckers mit den Lamellen 21.1 weit vom am Stecker 21 ist, so dass eine Höhendifferenz zwischen diesem Bereich und dem Anschlag des Steckers 21.2 ausgeglichen werden kann. Somit kann beispielsweise darauf reagiert werden, dass sich durch Temperatureinwirkungen das Feldgerät verändert. Der Lamellenstecker 21 ist über eine Feder 24 mit der Platine 25 der Adaptereinheit 10 verbunden. Über diese ist es möglich, auf Achs- oder Winkelversatz zu reagieren. Weiterhin ist die auf die Platine 25 wirkende Kraft maximal die Federkraft. Die äußere Kontaktverbindung 20.2 besteht aus zwei Lamellen 22, die leicht nach außen gebogen sind, so dass sie als Schleifkontakt wirken. Auf der Platine 25 sind - hier nicht gezeigt - die nötigen Bauteile untergebracht, um die abgegriffenen Signale auf den Signalausgang 26 zu geben, bei dem es sich beispielsweise um einen Ausgang für einen 4-oder 8-poligen Stecker handelt. Der Elektronikeinsatz wird auf diesen Signalausgang 26 gesteckt. Die Drehbarkeit lässt sich dann realisieren, indem der Elektronikeinsatz gedreht wird und die Adaptereinheit 10 mitnimmt. Ein Vorteil ist auch, dass sich die nötigen Elemente der Adaptereinheit 10 auf einer Platine 25 anordnen lassen. Das Gehäuse 23 der Adaptereinheit 10 ist zylindrisch ausgestaltet, hier bestehend aus zwei Halbschalen. Eine kompakte Version, die passend mit einem Abschluss verschlossen wird, ist jedoch auch möglich. Diese zylindrische Ausgestaltung hilft bei der Montage und schützt auch die Kontaktverbindungen 20.

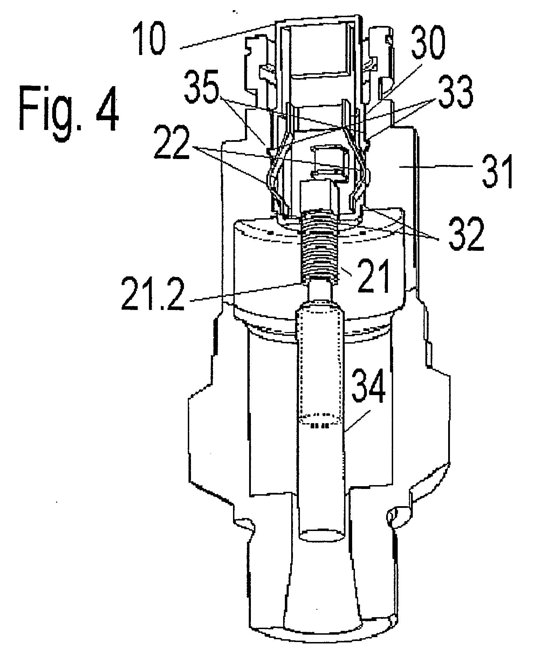

In der Fig. 4 ist die Adaptereinheit 10 der ersten Variante in Verbindung mit dem oberen Abschnitt 31 des Sensors 2 dargestellt. Die Adaptereinheit 10 ist in die Führung 30 eingebracht. In dieser lassen sich entsprechende O-Ringe zur Abdichtung einbringen. Weiterhin ist der obere Abschnitt 31 so ausgestaltet, dass ein Abschnitt der Elektronikeinheit 3 aufgenommen und ebenfalls entsprechend abgedichtet werden kann. Aufgrund der Ausgestaltung der Adaptereinheit 10 kann sie nicht weiter als bis zum Anschlag 32 der Adapterführung 30 eingebracht werden, so dass sich ein definierter Abstand zwischen der Adaptereinheit 10 und dem Sensor 2, bzw. zwischen der Adaptereinheit 10 und der Elektronikeinheit 3 ergibt. Somit kann die Adaptereinheit 10 also bei der Montage nicht zu weit hereingedrückt werden. Somit stützt sich der obere Teil des Feldgerätes 1 in Richtung Elektronikeinheit 3 auf diese Führung 30 und nicht auf den Lamellenstecker 21. Die Nase 33 verhindert das Herausfallen der Adaptereinheit 10, nachdem sie bei der Montage in eine entsprechend angebrachte Aussparung 35 eingeschnappt ist. Die innere Kontaktverbindung 20.1 steckt in einem Mittenbolzen 34, um dort das eigentliche Sensorsignal abzugreifen. Gut zu erkennen ist auch, dass durch die Ausgestaltung des Lamellensteckers 21 ein Höhenunterschied zwischen dem Mittenbolzen 34 und dem Anschlag 21.2 des Lammelensteckers 21 ausgeglichen werden kann. Die äußere Kontaktverbindung 20.2 ist hier direkt mit dem oberen Abschnitt des Sensors 31 verbunden, kann also beispielsweise Masse abgreifen. Die Lamellen 22 sind vorzugsweise so ausgestaltet, dass sie ein rundes Profil aufweisen, so dass sie also zwar einen elektrischen Kontakt herstellen, jedoch nicht das Gegenstück beschädigen.

### Bezugszeichenliste

- 1: Feldgerät
- 1.1: Achse des Feldgerätes
- 2: Sensor
- 3: Elektronikeinheit
- 3.1: Hals
- 4: Gehäuse
- 4.1: Gehäuse-Deckel
- 10: Adaptereinheit
- 11: Abgreifeinheit
- 11.1: Lamellenstecker
- 11.2: Platine
- 11.3: Anschlussstelle
- 12: Steckereinheit
- 12.1: Buchse
- 12.2: Topf
- 12.3: Platine
- 12.4: Haltering
- 13: Drehbare Zwischeneinheit
- 14: Feder
- 20: Kontaktverbindung
- 20.1: Innere Kontaktverbindung
- 20.2: Äußere Kontaktverbindung
- 21: Lamellenstecker
- 21.1: Bereich der Lamellen des Lamellensteckers
- 21.2: Anschlag des Lamellensteckers
- 22: Lamelle
- 23: Adaptereinheit-Gehäuse
- 24: Feder
- 25: Platine
- 26: Signalausgang
- 30: Adapterführung
- 31: Oberer Abschnitt des Sensors
- 32: Anschlag
- 33: Nase
- 34: Mittenbolzen
- 35: Aussparung

## Patentansprüche

1. Feldgerät (1) zur Bestimmung und/oder Überwachung mindestens einer physikalischen oder chemischen Prozessgröße eines Mediums,
mit mindestens einem Sensor (2),
mit mindestens einer Elektronikeinheit (3),
und
mit mindestens einer Adaptereinheit (10) zwischen Sensor (2) und Elektronikeinheit (3), die mindestens ein elektrisches Signal vom Sensor (2) zur Elektronikeinheit (3) überträgt,
**dadurch gekennzeichnet,**
**dass** in der Adaptereinheit (10) mindestens eine um die Längsachse (1.1) des Feldgerätes (1) beliebig drehbare Kontaktverbindung (20) zum Abgriff des mindestens einen Signals des Sensors (2) vorgesehen ist,
**dass** in der Adaptereinheit (10) mindestens eine innere Kontaktverbindung (20.1) und mindestens eine äußere Kontaktverbindung (20.2) für den Abgriff von zwei Signalen vorgesehen sind, welche konzentrisch um die Längsachse (1.1) des Feldgerätes (1) angeordnet sind und welche unterschiedliche relative Abstände zum Sensor entlang der Längsachse aufweisen,
und
**dass** es sich bei der inneren Kontaktverbindung (20.1) um einen Schleifkontakt in Form eines Lamellensteckers handelt, wobei der Lamellenstecker über eine Feder (24) mit einer Platine (25) der Adaptereinheit (10) verbunden ist.

2. Feldgerät (1) nach Anspruch 1,
wobei,
die äußere Kontaktverbindung (20.2) mindestens eine als Schleifkontakt wirkende Lamelle (22) aufweist.

3. Feldgerät (1) nach Anspruch 1 oder 2,
wobei,
dass der Bereich der Lamellen (21.1) des Lamellensteckers (21) derartig relativ zum Anschlag (21.2) des Lamellensteckers (21) angeordnet ist, dass möglichst optimal große Abstandsschwankungen zwischen Sensor (1) und Adaptereinheit (10) ausgleichbar sind.

## Claims

1. Field device (1) for determining and/or monitoring at least one physical or chemical process variable of a medium,
with at least one sensor (2),
with at least one electronic unit (3),
and
with at least one adapter unit (10) between the sensor (2) and the electronic unit (3), which transmits at least one electrical signal from the sensor (2) to the electronic unit (3), **characterized in that**
at least one contact connection (20) is provided in the adapter unit (10), said contact connection being designed to capture at least one signal of the sensor (2) and being rotatable in any direction along the longitudinal axis (1.1) of the field device (1),
at least one internal contact connection (20.1) and at least one external contact connection (20.2) are provided in the adapter unit (10), said connections being designed to capture two signals and being arranged concentrically along the longitudinal axis (1.1) of the field device (1) and being at different relative distances from the sensor along the longitudinal axis,
and
**in that** the internal contact connection (20.1) is a rubbing contact in the form of a ribbed connector, wherein the ribbed connector is connected to a board (25) of the adapter unit (10) via a spring (24).

2. Field device (1) as claimed in Claim 1, wherein the external contact connection (20.2) has at least one rib (22) that acts as a rubbing contact.

3. Field device (1) as claimed in Claim 1 or 2, wherein the area of the ribs (21.1) of the ribbed connector (21) is arranged in relation to the limit stop (21.2) of the ribbed connector (21) in such a way that large variations in the distance between the sensor (1) and the adapter unit (10) can be compensated for as optimally as possible.

## Revendications

1. Appareil de terrain (1) destiné à la détermination et/ou à la surveillance d'au moins une grandeur process physique et/ou chimique d'un produit,
avec au moins un capteur (2),
avec au moins une unité électronique (3),
et
avec au moins une unité adaptatrice (10) entre le capteur (2) et l'unité électronique (3), qui transmet au moins un signal électrique du capteur (2) vers l'unité électronique (3), **caractérisé en ce**
**qu'**est prévue dans l'unité adaptatrice (10) au moins une connexion par contact (20) orientable à volonté autour de l'axe longitudinal (1.1) de l'appareil de terrain (1), laquelle connexion est destinée à prélever au moins un signal du capteur (2),
en ce qu'est prévue dans l'unité adaptatrice (10) au moins une connexion par contact intérieure (20.1) et au moins une connexion par contact extérieure (20.2) pour le prélèvement de deux signaux, lesquelles connexions sont disposées de façon concentrique autour de l'axe longitudinal (1.1) de l'appareil de terrain (1) et qui présentent le long de l'axe longitudinal des distances relatives différentes par rapport au capteur,
et
en ce que, concernant la connexion par contact intérieure (20.1), il s'agit d'un contact à frottement sous la forme d'une fiche à lamelles (21), la fiche à lamelles étant reliée avec la carte (25) de l'unité adaptatrice (10) par l'intermédiaire d'un ressort (24).

2. Appareil de terrain (1) selon la revendication 1, pour lequel la connexion par contact extérieure (20.2) présente au moins une lamelle (22) agissant en tant que contact à frottement.

3. Appareil de terrain (1) selon la revendication 1 ou 2, pour lequel la zone des lamelles (21.1) de la fiche à lamelles (21) est disposée par rapport à la butée (21.2) de telle sorte à pouvoir compenser de façon aussi optimale que possible de grandes variations de distance entre le capteur (1) et l'unité adaptatrice (10).
